# EUROPEAN PATENT APPLICATION

(11) **EP 3 197 054 A1**
(43) Date of publication of application: **26.07.2017**
(21) Application number: 14902034.9
(22) Date of filing: 15.12.2014
(51) Int. Cl.: H03K 19/00

(54) **DYNAMIC CLOCK SWITCHING METHOD AND APPARATUS AS WELL AS COMPUTER READABLE MEDIUM**

(30) Priority: 16.09.2014 CN 201410472907
(71) Applicant: Sanechips Technology Co., Ltd., Shenzhen, Guangdong 518055 (CN)
(72) Inventor: XIA, Maosheng, Shenzhen, Guangdong 518085 (CN); ZHANG, Qing, Shenzhen, Guangdong 518085 (CN)
(74) Representative: Brevalex
(86) International application number: PCT/CN2014/093859
(87) International publication number: WO 2016/041278

(57) **Abstract**

Disclosed are a dynamic clock switching method and apparatus as well as a computer readable medium. The apparatus comprises a clock selection signal generation unit (11), a clock enable signal generation unit (12), a synchronization unit (13) and a gating unit (14); the clock selection signal generation unit (11) is configured to generate two or more clock selection signals and transmit same to the clock enable signal generation unit (12); the clock enable signal generation unit (12) is configured to generate a clock enable signal based on a plurality of clock selection signals transmitted by the clock selection signal generation unit (11) and transmit the clock enable signal to the synchronization unit (13); the synchronization unit (13) is configured to synchronize the clock enable signal and transmit the synchronized clock enable signal to the gating unit (14); and the gating unit (14) is configured to open or close the output of the clock signal based on the clock enable signal synchronized by the synchronization unit (13).

## Description

### TECHNICAL FIELD

The disclosure relates to a digital circuit technology and in particular to a method and apparatus for dynamically switching clocks, and a computer readable medium.

### BACKGROUND

At present, a digital system is increasingly complex in function and has an increasingly high requirement on power consumption. According to demands on the function and power consumption, the digital system usually needs to dynamically switch a plurality of different working clocks.

Existing dynamic clock switching technologies have the following defects: 1) a number of the clocks to be switched is limited, and usually only the switching of two clocks is supported; 2) the frequencies of the clocks to be switched are limited, for example, the difference of the frequencies of the clocks to be switched should not be too large or the frequency of a clock to be switched is a certain multiple of the frequency of another clock to be switched; and 3) the operation is comparatively complex, and multiple operations are needed to be performed on associated registers during the clock switching. These defects would impair the performance and flexibility of the digital system.

From the above, there are problems of limitations to the number and frequencies of clocks to be switched and of cumbersome operation in the related dynamic clock switching technology, so that the excellent performance and the higher flexibility of the digital system is difficult to be ensured.

### SUMMARY

Embodiments of the disclosure provide a method and apparatus for dynamically switching clocks to address the problem that dynamic switching of clocks is limited in a number and frequency of the clocks to be switched and complicated in operation.

The solutions of the disclosure are implemented as follows.

An apparatus for dynamically switching clocks includes: a clock selection signal generation unit, a clock enable signal generation unit, a synchronization unit and a gating unit, in the apparatus,
the clock selection signal generation unit is configured to generate two or more clock selection signals and transmit the two or more clock selection signals to the clock enable signal generation unit, the clock selection signals have the following characteristics: a number of the clock selection signals is equal to a number of the clocks to be switched; at any moment, one and only one clock selection signal is at an active high or low level; and at any moment, two and only two clock selection signals reverse towards opposite directions with respect to each other;
the clock enable signal generation unit is configured to generate clock enable signals based on the clock selection signals transmitted from the clock selection signal generation unit and transmit the clock enable signals to the synchronization unit;
the synchronization unit is configured to synchronize the clock enable signals and transmit the synchronized clock enable signals to the gating unit; and
the gating unit is configured to switch on or off outputs of clock signals based on the clock enable signals synchronized by the synchronization unit.

In a particular embodiment, the synchronization unit is further configured to return the synchronized clock enable signals as feedback control signals to the clock enable signal generation unit; and the clock enable signal generation unit is configured to generate the clock enable signals based on the clock selection signals and the feedback control signals returned by the synchronization unit, with only one of the clock enable signals being enabled at any moment.

In a particular embodiment, the clock enable signal generation unit is further configured to perform a delay processing on the feedback control signals returned by the synchronization unit, and then generate the clock enable signals based on the feedback control signals subjected to the delay processing and the clock selection signals which are currently input.

In a particular embodiment, the delay processing refers to a delay of one clock cycle.

In a particular embodiment, the clock selection signal generation unit is further configured to generate the clock selection signals based on a configuration clock domain.

A method for dynamically switching clocks includes:
generating, by a clock selection signal generation unit, two or more clock selection signals and then transmitting the two or more clock selection signals to a clock enable signal generation unit, the clock selection signals having the following characteristics: a number of the clock selection signals is equal to a number of the clocks to be switched; at any moment, one and only one clock selection signal is at an active high or low level; and at any moment, two and only two clock selection signals reverse towards opposite directions with respect to each other;
generating, by the clock enable signal generation unit, two or more clock enable signals based on the two or more clock selection signals and then transmitting, by the clock enable signal generation unit, the clock enable signals to a synchronization unit;
synchronizing, by the synchronization unit, the clock enable signals and then transmitting, by the synchronization unit, the synchronized clock enable signals to a gating unit; and
switching on or off, by the gating unit, outputs of clock signals based on the synchronized clock enable signals.

In a particular embodiment, the method further includes: returning, by the synchronization unit, the synchronized clock enable signals as feedback control signals to the clock enable signal generation unit; and generating, by the clock enable signal generation unit, the clock enable signals based on the clock selection signals and the feedback control signals returned by the synchronization unit, with only one of the clock enable signals being enabled at any moment.

In a particular embodiment, generating the clock enable signals based on the clock selection signals and the feedback control signals returned by the synchronization unit includes:
performing, by the clock enable signal generation unit, a delay processing on the feedback control signals, and then generating, by the clock enable signal generation unit, the clock enable signals based on the feedback control signals subjected to the delay processing and the clock selection signals which are currently input.

In a particular embodiment, the delay processing refers to a delay of one clock cycle.

In a particular embodiment, the clock selection signal generation unit generates the clock selection signals based on a configuration clock domain.

A computer-readable medium is provided in which executable instructions are stored, the executable instructions are configured to execute the above methods for dynamically switching clocks.

In embodiments of the disclosure, a number of clock selection signals generated by a clock selection signal generation unit is equal to a number of the clocks to be switched; and at any moment, one and only one clock selection signal is at an active high or low level and two and only two clock selection signals reverse towards opposite directions with respect to each other. There is no limitation to the number and the frequencies of clocks. There is no need to perform an additional processing before or after switching of clocks, and a rapid switching can be performed without burrs among a plurality of clock signals. Thus, the problem is addressed that dynamic switching of clocks is limited in the number and the frequencies of the clocks to be switched and complicated in operation, and the usability and flexibility of a digital system are improved.

### BRIEF DESCRIPTION OF THE DRAWINGS

Fig. 1 is a schematic diagram illustrating a structure of an apparatus for dynamically switching clocks in a case of selecting one from a plurality of clocks according to Embodiment 1 of the disclosure;
Fig. 2 is a schematic diagram illustrating a coding mode for clock selection signals in a dynamic clock switching for selecting one from four clocks according to Embodiment 2 of the disclosure;
Fig. 3 is a schematic diagram illustrating a structure and a signal logic of an apparatus for dynamically switching clocks in a case of selecting one from four clocks according to Embodiment 2 of the disclosure;
Fig. 4 is a waveform diagram illustrating a clock selection signal processed by a clock selection signal generation unit according to Embodiment 2 of the disclosure;
Fig. 5 is a waveform diagram illustrating an output clock based on a delay clock enable signal feedback control according to Embodiment 2 of the disclosure; and
Fig. 6 is a flowchart illustrating a method for dynamically switching clocks in a case of selecting one from a plurality of clocks according to Embodiment 3 of the disclosure.

### DETAILED DESCRIPTION

In order to make objects, technical solutions and advantages of the disclosure more apparent, the disclosure will be described below in detail according to embodiments of the disclosure and with reference to accompanying drawings.

### Embodiment 1

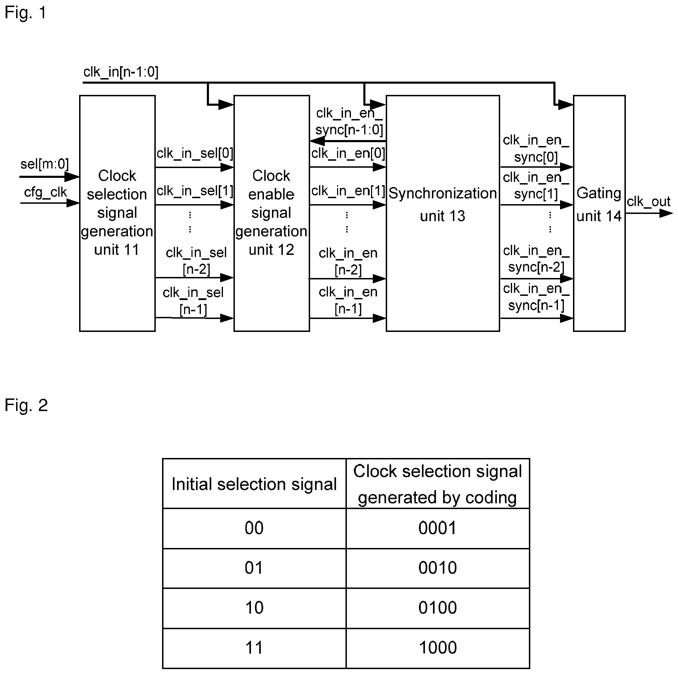

As shown in Fig. 1, an apparatus for dynamically switching clocks provided by the disclosure, as a dynamic multi-clock switching circuit, includes: a clock selection signal generation unit 11, a clock enable signal generation unit 12, a synchronization unit 13 and a gating unit 14. The clock selection signal generation unit 11 generates a plurality of clock selection signals, the clock enable signal generation unit 12 generates clock enable signals based on the plurality of clock selection signals and transmits the generated clock enable signals to the synchronization unit 13, so that the clock enable signals are synchronized by the synchronization unit 13. The gating unit 14 switches on or off outputs of clocks according to the synchronized clock enable signals.

The clock selection signal generation unit 11 is configured to generate clock selection signals. The clock selection signals have the following characteristics: 1) a number of the clock selection signals is equal to a number of the clocks to be switched; 2) at any moment, one and only one clock selection signal is at an active high or low level, and the rest clock selection signals are at an inactive low or high level; and 3) at any moment, two and only two clock selection signals reverse towards opposite directions with respect to each other, for example, one reverses from a low level to a high level and the other reverses from a high level to a low level.

In embodiments of the disclosure, the clock selection signals generated by the clock selection signal generation unit 11 come from a configuration clock domain. For the 'clock domain', if a signal is driven (or triggered) by a clock clk_in1, the signal belongs to a clock domain clk_in1. The clock selection signal may be generated by being configured by a piece of software or being decoded by a piece of hardware. That is, the clock selection signal generation unit may be implemented as a piece of hardware or a piece of software, however, the clock selection signal generated in these two ways must have the foregoing three characteristics.

In embodiments of the disclosure, the clock selection signal generation unit 11 may be a circuit having a function of: generating one-hot codes by coding m (m is an integer not less than 2) input initial selection signals (e.g. sel[m:0] shown in Fig. 1 which represents a binary code) using a configuration clock (e.g. cfg_clk shown in Fig. 1) and outputting the one-hot codes (as shown in Fig. 1, clk_in_sel[0], clk_in_sel[1],..., clk_in_sel[n-2], clk_in_sel[n-1], and n being an integer not less than 2). In this case, the one-hot codes are the foregoing clock selection signals. That is, clk_in_sel[0], clk_in_sel[1],..., clk_in_sel[n-2], clk_in_sel[n-1] shown in Fig. 1 are clock selection signals generated by the clock selection signal generation unit 11, and in embodiments of the disclosure, the clock selection signal generation unit 11 can generate a plurality of (at least two or more) clock selection signals. The clk_in[n-1:0] shown in Fig. 1 represents n-1 clock signals to be switched.

The clock enable signal generation unit 12 is configured to generate a plurality of clock enable signals based on the plurality of clock selection signals. In embodiments of the disclosure, the clock enable signals generated by the clock enable signal generation unit 12 have the following characteristics: each clock has a separate clock enable signal, and only one clock enable signal is enabled at any moment; and the clock enable signals are generated based on the foregoing clock selection signals and the feedback control signals returned by the synchronization unit. That is, in embodiments of the disclosure, the clock enable signal generation unit 12 specifically generates clock enable signals based on the clock selection signals generated by the clock selection signal generation unit 11 together with the feedback control signals returned by the synchronization unit 13, for example, the feedback control signals are clock enable signals synchronized by the synchronization unit 13, the clock enable signal generation unit 12 performs a delay processing (a delay of one clock cycle) for the feedback control signals returned by the synchronization unit 13 and then generates each clock enable signal based on the delayed feedback control signals together with each of the clock selection signals. As shown in Fig. 1, the clock enable signal generation unit 12 generates n new clock enable signals clk_in_en[O], clk_in_en[1], ..., clk_in_en[n-2], clk_in_en[n-1] based on n clock selection signals clk_in_sel[0], clk_in_sel[1],..., clk_in_sel[n-2], clk_in sel[n-1] as well as n (n is an integer not less than 2) clock enable signals clk_in_en_sync[n-1:0] that are processed by the synchronization unit and returned to the clock enable signal generation unit.

In embodiments of the disclosure, the synchronization unit 13 is configured to synchronize the clock enable signals transmitted from the clock enable signal generation unit 12 to eliminate the effect of a semi-stable state. The synchronization unit 13 returns the synchronized clock enable signals to the clock enable signal generation unit 12, so as to generate new clock enable signals and transmit the new clock enable signals to the gating unit 14. Thus the gating unit 14 can control output of control signals. As shown in Fig. 1, clk_in en sync[0] to clk_in_en_sync[n-1] which represent n clock enable signals synchronized by the synchronization unit 13 are, on one hand, returned to the clock enable signal generation unit 12 and, on the other hand, transferred to the gating unit 14.

In embodiments of the disclosure, the gating unit 14 switches on or off outputs of clock signals according to the clock enable signals synchronized by the synchronization unit 13, and the gated clock signals are output after passing a logic OR gate. As shown in Fig. 1, the gating unit 14 switches on or off clocks according to the clock enable signals clk_in_en_sync[0] to clk_in_en_sync[n-1] synchronized by the synchronization unit 13. The clk_out shown in Fig. 1 represents an output signal generated by performing an Or processing on gated clocks.

In a practical application, each unit in the apparatus can be implemented as a Field Programmable Gate Array (FPGA).

In the foregoing apparatus provided in an embodiment of the disclosure, a dynamic switching of clocks is insensitive to frequencies of clocks and is therefore more widely applicable fields and more enhanced universality.

### Embodiment 2

The specific implementation of the disclosure is described below by taking a dynamic clock switching in a case of selecting one from four clocks as an example.

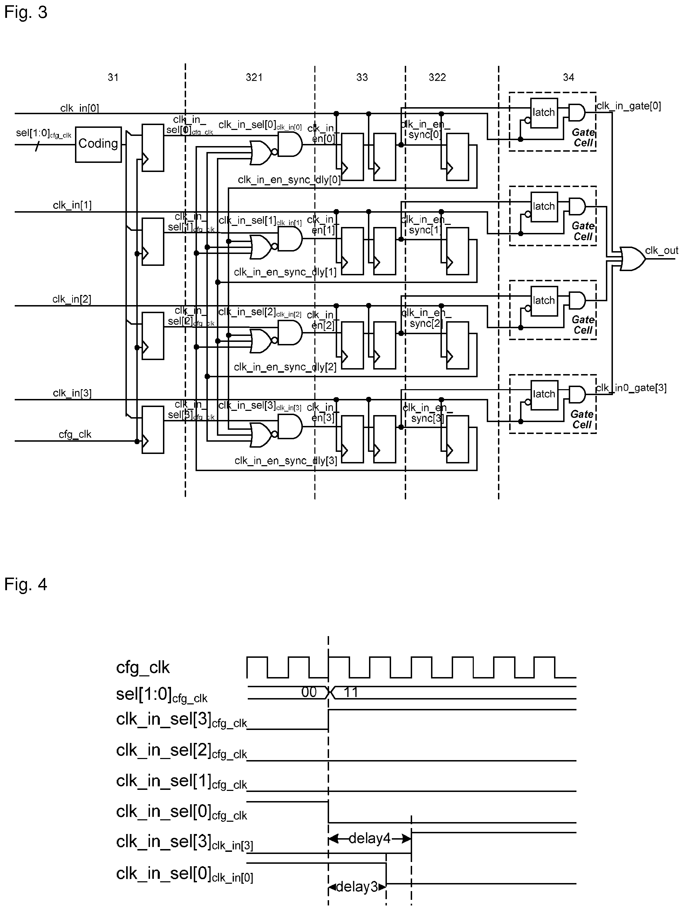

In the embodiment, multi-bit clock selection signals are needed to select a clock from a plurality of clocks, and a case of selecting one from four clocks is taken as an example, two-bit clock selection signals coded in the way shown in Fig. 2 are needed. As shown in Fig. 3, an apparatus for dynamically switching clocks in a case of selecting one from four clocks may include a clock selection signal generation unit 31, a clock enable signal generation unit, a synchronization unit 33 and a gating unit 34. The clock enable signal generation unit includes two parts: a first part 321 and a second part 322. The first part 321 transmits a signal between the clock selection signal generation unit 31 and the synchronization unit 33, and the second part 322 transmits a signal between the synchronization unit 33 and the first part 321.

As shown in Fig. 3, in the embodiment, the clock selection signal generation unit 31 generates one-hot codes by coding n (n is an integer not less than 2) input initial selection signals sel [n:0] using a configuration clock cfg_clk and outputs the one-hot codes. The one-hot codes are clock selection signals. If the clock enable signal generation unit 31 generates clock selection signals directly using input initial selection signals, and due to transmission of multi-bit data across time domains, the burrs are generated in an output clock. The clk_in[i] in Fig. 3 represents clock signals to be switched. In the embodiment, the clock selection signal generation unit 31 adopts the coding mode shown in Fig. 2. In Fig. 2, four states 00, 01, 10 and 11 of an initial selection signal of a binary code correspond to clock signals clk_in[0], clk_in[1], clk_in[2] and clk_in[3] to be selected, respectively. If switching is performed from clk_in[0] to clk_in[3], the initial selection signal changes from 00 to 11, and on a condition of no coding processing is performed, the burrs may be generated in the output clock. In embodiments of the disclosure, the clock selection signals generated by the clock enable signal generation unit 31 have the following characteristics: 1) a number of the clock selection signals is equal to a number of the clocks to be switched; 2) at any moment, one and only one clock selection signal is at an active high (or low) level, the rest clock selection signal(s) is(are) at an inactive low (or high) level; and 3) at any moment, two and only two clock selection signals reverse towards opposite directions with respect to each other, for example, one reverses from a low level to a high level and the other reverses from a high level to a low level. The clock selection signals coming from a configuration clock domain can be generated by being configured by a piece of software or being decoded by a piece of hardware. With clock selection signals having the foregoing characteristics, four states 0001, 0010, 0100 and 1000 of the coded clock selection signal correspond to selection clocks clk_in[0], clk_in[1], clk_in[2] and clk_in[3], respectively. In this case, when switching is performed from the clock signal clk_in[0] to the clock signal clk_in[3], a signal for selecting clk_in[0] changes from an active state to an inactive state, a signal for selecting clk_in[3] changes from an inactive state to an active state, and signals for selecting clk_in[1] and clk_in[2] are still inactive, and the state of the clock selection signal changes from 0001 to 1000, thus avoiding the occurrence of a situation that clk_in[1] and clk_in[3] are selected at the same time and avoiding the burrs in an output clock. Fig. 4 shows transmission of the multi-bit clock selection signals of a multi-bit binary code across clock domains, and in Fig. 4, clk_in_sel[i]_{cfg_clk} (0≤i≤n-1) represents the generated clock selection signals, and sel[1:0]_{cfg_clk} represents the initial selection signal.

When the clock signal is switched from clk_in[0] to clk_in[3], the clock enable signal generation unit needs to generate a clock enable signal according to the clock selection signals, the clock enable signal generation unit needs to, on one hand, disable the former clock (e.g. the foregoing clk_in[0]), and on the other hand, enable a new clock (e.g. the foregoing clk_in[3]). In order to generate no burrs in an output clock, the order needs to be taken that the former clock is disabled and then a new clock is enabled. In embodiments of the disclosure, the clock enable signal generation unit generates currently needed clock enable signals based on feedback control signals returned by the synchronization unit 33 and clock selection signals currently generated by the clock selection signal generation unit 31. For example, as shown in Fig. 3, the clock selection signals clk_in_sel[i]_{cfg_clk} (0≤i≤n-1) currently generated by the clock selection signal generation unit 31 are output, delayed by a certain time and then input to the first part 321 of the clock enable signal generation unit. In Fig. 3, clk_in_sel[i]_{clk_in[i]} represents a signal which is generated by delaying the clock selection signal clk_in sel[i]_{cfg_clk} output by the clock selection signal generation unit 31 and then input to the clock enable signal generation unit, feedback control signals clk_in_en_sync[j] (0≤j≤n-1 and j≠ i) returned from the synchronization unit 33 is input to the second part 322 of the clock enable signal generation unit; the second part 322 of the clock enable signal generation unit performs a delay processing on the input feedback control signals clk_in_en_sync[j] (that is, delaying the input feedback control signals by one clock cycle) and then outputs the delayed feedback control signals to the first part 321; clk_in_en_sync_dly[j] shown in Fig. 3 is a signal generated after the second part 322 of the clock enable signal generation unit delays clk_in_en_sync[j] by one clock cycle, the first part 321 performs a combinatory logic processing based on the delayed feedback control signals clk_in_en_sync_dly[j] and the currently input clock selection signals clk_in_sel[i]_{clk_in[i]} to generate a currently needed clock enable signal clk_in_en[i] and output the currently needed clock enable signal clk_in_en[i] to the synchronization unit 33. The feedback control signal clk_in_en_sync[j] is a signal output after the synchronization unit 33 performs a synchronization processing on the clock enable signals clk_in_en[j] previously input.

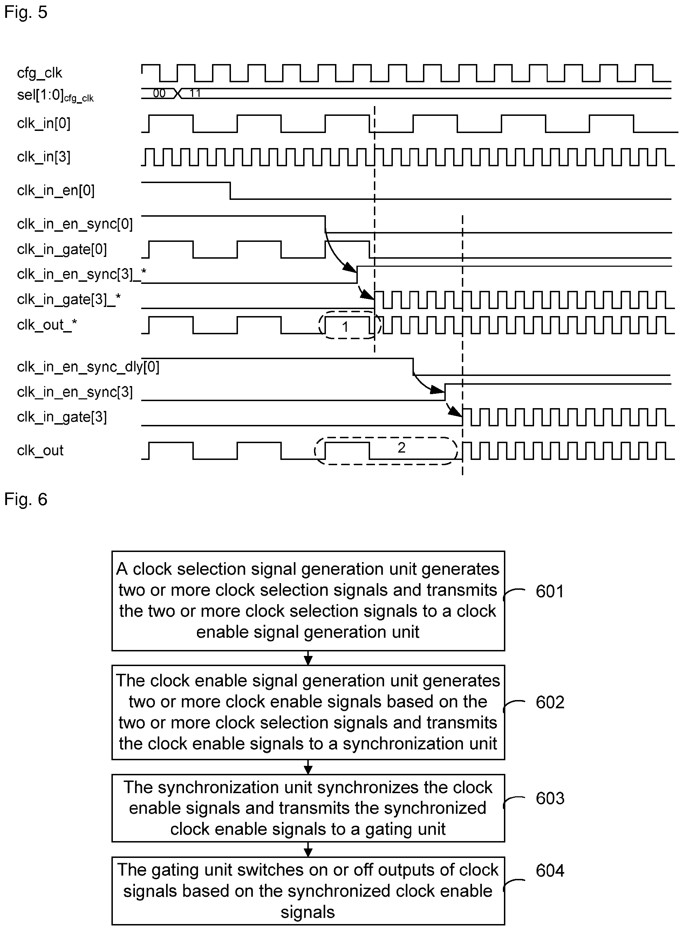

In embodiments of the disclosure, the synchronized clock enable signals are used as input of the clock enable signal generation unit, that is, as feedback control signals for generating new clock enable signals, and if the clock enable signal generation unit determines that each of the rest clock enable signals are at a low level, a new clock enable signal is enabled. To guarantee the integrity of an output clock cycle, feedback control signals to be input to the clock enable signal generation unit should be delayed by one clock cycle before being used, and as shown in Fig. 3, the delay is performed by the second part 322 of the clock enable signal generation unit. As shown by the circle 1 shown in Fig. 5, if clock enable signals clk_in_en_sync[i] before being delay are used as feedback control signals, a new clock signal is switched in a case that the last cycle of the former clock signal may be not completely output, when the signal is output; as shown in Fig. 3, if a new clock enable signal is generated using delayed clock enable signals clk_in_en_sync_dly[i], a new clock signal is switched after the last cycle of the former clock signal is completely output when the signal is output, as indicated in circle 2 in Fig. 5. In Fig. 5, clk_out_* represents an output signal generated with the use of signals clk_in_en_sync[i] but not delayed signals clk_in_en_sync_dly[i] as feedback control signals, and clk_out represents an output signal generated with the use of signals clk_in_en_sync_dly[i] as feedback control signals. An output signal clk_out_* is generated by performing an Or processing on output control signals clk_in_gate[0] and clk_in_gate[3]_* passing through the gating unit 34; the signal clk_in_gate[3]_* is a gated clock signal generated by using signals clk_in_en_sync[i] as feedback control signals; an output signal clk_out is generated by performing an Or processing on output control signals clk_in_gate[0] and clk_in_gate[3] passing through the gating unit 34, and clk_in_gate[3] represents a gated clock signal generated by using delayed signals clk_in_en_sync_dly[i] as feedback control signals.

The synchronization unit 33 is configured to synchronize clock enable signals. As shown in Fig. 3, the synchronization unit 33 generates signals clk_in_en_sync[i] after synchronizing clock enable signals clk_in_en[i] and separately outputs the signals clk_in_en_sync[i] to the gating unit 34 and the second part 322 of the clock enable signal generation unit.

The gating unit 34 is configured to switch off or on clocks based on the clock enable signals synchronized by the synchronization unit 33. As shown in Fig. 3, gated clock signals clk_in_gate[0] to clk_in_gate[3] are generated after the synchronized clock enable signals clk_in_en_sync[i] pass the gating unit 34. An output signal clk_out is generated by performing an Or processing on the gated clocks when switching is performed from the clk_in[0] to the clk_in[3].

### Embodiment 3

The embodiment of the disclosure provides a method for dynamically switching clocks performed by the apparatus for dynamically switching clocks of Embodiment 1, and as shown in Fig. 7, the method may mainly include the following steps.

At Step 601: a clock selection signal generation unit generates two or more clock selection signals and transmits the two or more clock selection signals to a clock enable signal generation unit. The clock selection signals have the following characteristics: a number of the clock selection signals is equal to a number of the clocks to be switched; at any moment, one and only one clock selection signal is at an active high or low level; and at any moment, two and only two clock selection signals reverse towards opposite directions with respect to each other.

Here, the clock selection signal generation unit generates the clock selection signals based on a configuration clock domain.

At Step 602: the clock enable signal generation unit generates two or more clock enable signals based on the two or more clock selection signals and then transmits the clock enable signals to a synchronization unit.

The synchronization unit synchronizes the clock enable signals and then returns the synchronized clock enable signals as feedback control signals to the clock enable signal generation unit; and the clock enable signal generation unit generates the clock enable signals based on the clock selection signals and the feedback control signals returned by the synchronization unit. At any moment, only one of the clock enable signals is enabled.

For example, the clock enable signal generation unit performs a delay processing on the feedback control signals and then generates the clock enable signals based on the feedback control signals subjected to the delay processing and clock selection signals which are currently input. Here, the delay processing refers to a delay of a clock cycle.

At Step 603: the synchronization unit synchronizes the clock enable signals and then transmits the synchronized clock enable signals to a gating unit.

At Step 604: the gating unit switches on or off outputs of clock signals based on the synchronized clock enable signals.

The details of implementation of the method provided in the embodiment can be directly obtained with reference to the description of Embodiment 1 or 2 and are thus not repeated here. Moreover, the method in the embodiment is also applicable to the apparatus for dynamically switching clocks in a case of selecting one from four clocks in Embodiment 2, and its implementation process is identical to the foregoing flow and is thus not repeated here.

It should be appreciated by those skilled in the art that each module or step described in the disclosure can be realized by a general-purpose computing device and that the modules or steps may be integrated on a single computing device or distributed on a network consisting of a plurality of computing devices. Alternatively, the modules or steps may be realized by program codes which may be executed by a computing device, so that the modules or steps can be stored in a storage device for execution by the computing device, and in some cases, the steps shown or described herein can be executed in an order different from the order presented herein, or the modules or steps are formed into each integrated circuit module respectively, or several of the modules or steps are formed into a singe integrated circuit module. Therefore, the disclosure is not limited to combination of any specific hardware and software.

What are described above are merely particular embodiments of the disclosure, but are not to be construed as limiting the scope of the disclosure.

## Claims

1. An apparatus for dynamically switching clocks, comprising: a clock selection signal generation unit, a clock enable signal generation unit, a synchronization unit and a gating unit, wherein
the clock selection signal generation unit is configured to generate two or more clock selection signals and transmit the two or more clock selection signals to the clock enable signal generation unit, wherein the clock selection signals have the following characteristics: a number of the clock selection signals is equal to a number of the clocks to be switched; at any moment, one and only one clock selection signal is at an active high or low level; and at any moment, two and only two clock selection signals reverse towards opposite directions with respect to each other;
the clock enable signal generation unit is configured to generate clock enable signals based on the clock selection signals transmitted from the clock selection signal generation unit and transmit the clock enable signals to the synchronization unit;
the synchronization unit is configured to synchronize the clock enable signals and transmit the synchronized clock enable signals to the gating unit; and
the gating unit is configured to switch on or off outputs of clock signals based on the clock enable signals synchronized by the synchronization unit.

2. The apparatus according to claim 1, wherein
the synchronization unit is further configured to return the synchronized clock enable signals as feedback control signals to the clock enable signal generation unit; and
the clock enable signal generation unit is configured to generate the clock enable signals based on the clock selection signals and the feedback control signals returned by the synchronization unit, wherein at any moment, only one of the clock enable signals is enabled.

3. The apparatus according to claim 2, wherein the clock enable signal generation unit is further configured to perform a delay processing on the feedback control signals returned by the synchronization unit, and then generate the clock enable signals based on the feedback control signals subjected to the delay processing and the clock selection signals which are currently input.

4. The apparatus according to claim 3, wherein the delay processing refers to a delay of one clock cycle.

5. The apparatus according to any one of claims 1 to 4, wherein the clock selection signal generation unit is further configured to generate the clock selection signals based on a configuration clock domain.

6. A method for dynamically switching clocks, comprising:
generating, by a clock selection signal generation unit, two or more clock selection signals and then transmitting the two or more clock selection signals to a clock enable signal generation unit, wherein the clock selection signals have the following characteristics: a number of the clock selection signals is equal to a number of the clocks to be switched; at any moment, one and only one clock selection signal is at an active high or low level; and at any moment, two and only two clock selection signals reverse towards opposite directions with respect to each other;
generating, by the clock enable signal generation unit, two or more clock enable signals based on the two or more clock selection signals and then transmitting, by the clock enable signal generation unit, the clock enable signals to a synchronization unit;
synchronizing, by the synchronization unit, the clock enable signals and then transmitting, by the synchronization unit, the synchronized clock enable signals to a gating unit; and
switching on or off, by the gating unit, outputs of clock signals based on the synchronized clock enable signals.

7. The method according to claim 6, wherein the method further comprises:
returning, by the synchronization unit, the synchronized clock enable signals as feedback control signals to the clock enable signal generation unit; and
generating, by the clock enable signal generation unit, the clock enable signals based on the clock selection signals and the feedback control signals returned by the synchronization unit, wherein at any moment, only one of the clock enable signals is enabled.

8. The method according to claim 7, wherein generating the clock enable signals based on the clock selection signals and the feedback control signals returned by the synchronization unit comprises:
performing, by the clock enable signal generation unit, a delay processing on the feedback control signals, and then generating, by the clock enable signal generation unit, the clock enable signals based on the feedback control signals subjected to the delay processing and the clock selection signals which are currently input.

9. The method according to claim 8, wherein the delay processing refers to a delay of one clock cycle.

10. The method according to any one of claims 6 to 9, wherein the clock selection signal generation unit generates the clock selection signals based on a configuration clock domain.

11. A computer-readable medium in which executable instructions are stored, wherein the executable instructions are configured to execute the method for dynamically switching clocks of any one of claims 6 to 10.
